Europäisches Patentamt

European Patent Office

Office européen des brevets

(11) Publication number: **0 399 254**
**A2**

# (12) EUROPEAN PATENT APPLICATION

(21) Application number: **90108295.8**

(51) Int. Cl.⁵: **G01R 33/06**

(22) Date of filing: **02.05.90**

(30) Priority: **26.05.89 JP 61302/89 U**

(43) Date of publication of application:
**28.11.90 Bulletin 90/48**

(84) Designated Contracting States:
**AT BE CH DE DK ES FR GB GR IT LI NL SE**

(71) Applicant: **OMRON CORPORATION**
**10, Tsuchido-cho, Hanazono, Ukyo-ku,**
**Kyoto-shi, Kyoto-fu(JP)**

(72) Inventor: **Akitsu, Yasushi, c/o Intellectual**
**Property Center**
**Omron Corporation, 20 Igadera, Shimokaiinji**
**Nagaokakyo-shi, Kyoto-fu(JP)**

(74) Representative: **Kahler, Kurt, Dipl.-Ing.**
**Postfach 1249 Gerberstrasse 3**
**D-8948 Mindelheim(DE)**

(54) **Magneto-electric transducer.**

(57) A pair of magneto-electric transducer ICs (4, 5) each incorporating a Hall device is mounted on either major surface of a planar lead member (1a) which may consist of an extension of one (1) of a plurality of fingers (1 to 3) of a lead frame, and their leads are connected to different fingers (1 to 3) of the lead frame in mutually parallel relationship. The thus composed magneto-electric transducer can detect a certain level of a magnetic field of either polaritiy and can thereby detect the presence of either S or N pole even though its structure is highly simple, compact and economical.

F I G. 1 (a)     F I G. 1 (b)

EP 0 399 254 A2

# MAGNETO-ELECTRIC TRANSDUCER

## TECHNICAL FIELD

The present invention relates to a magneto-electric transducer for detecting N and S poles.

## BACKGROUND OF THE INVENTION

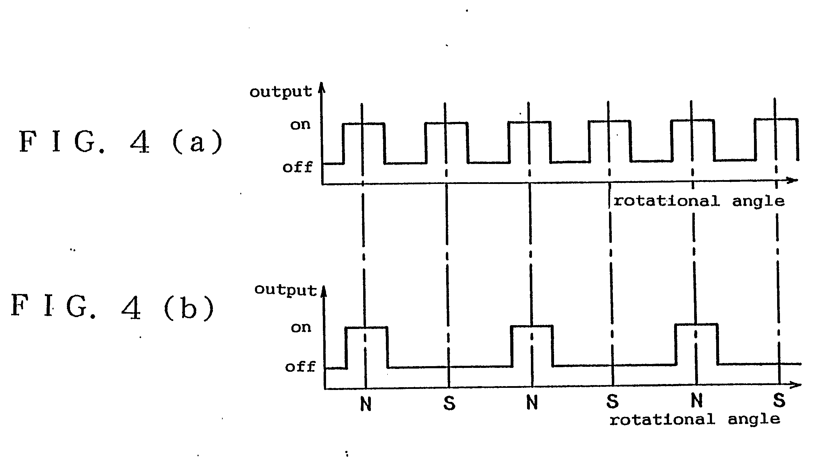

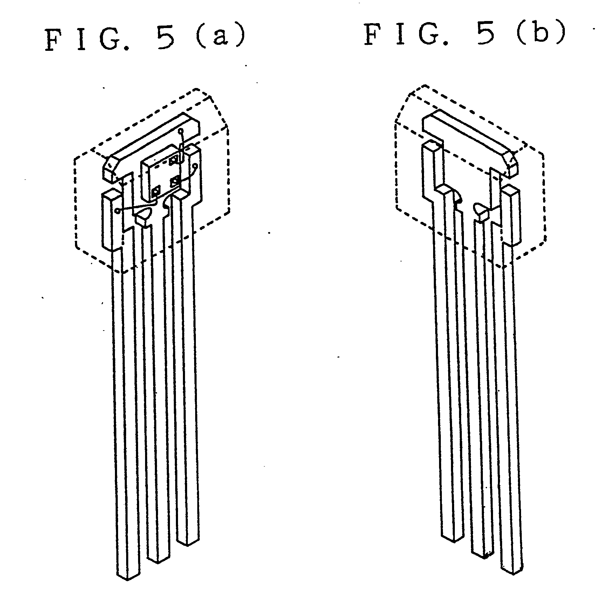

Conventionally, there have been known as magneto-electric transducers, alternating magnetic field type devices having an operating point near a zero point of the intensity of the magnetic field for detecting the transition of the magnetic field from N to S or from S to N. Also is known a uni-directional magnetic field type magneto-electric transducer which consists of a Hall IC mounted on a major surface of a base member included in a lead frame as illustrated in Figures 5(a) and (b) showing both of its major surfaces, and has an operating point at a certain positive level of the intensity of a magnetic field so as to detect the presence of an N pole as indicated in Figure 4(b).

However, according to such a conventional magneto-electric transducer, it is not possible to form by itself a bidirectional magnetic field type magneto-electric transducer which has an operating point in each of the positive and negative ranges of the intensity of a magnetic field. Therefore, conventionally, it has been possible to form such a bidirectional magneto-electric transducer which can detect the presence of either S or N pole only if it is combined with a specially designed processing circuit, and a substantially high cost has been necessary to produce it.

## BRIEF SUMMARY OF THE INVENTION

In view of such a problem of the prior art magneto-electric transducers, a primary object of the present invention is to provide a magneto-electric transducer which can detect the presence of either N or S pole at the same time by using a relatively simple structure.

A second object of the present invention is to provide a magneto-electric transducer which can detect the presence of either N or S pole by using a relatively compact structure.

These and other objects of the present invention can be accomplished by providing a magneto-electric transducer, comprising: a base member; a pair of magneto-electric transducer ICs mounted on the base member adjacent to each other; and lead means for connecting leads of the magneto-electric transducer ICs to an external circuit.

Thus, the transducer may have a detection level at each of certain positive and negative levels of a magnetic field so as to be capable of detecting the presence of either S or N pole of a magnet.

Preferably, the base member consists of a planar member, and the magneto-electric transducer ICs are mounted on either major surface of the base member. The lead means may consist of a plurality of fingers of a lead frame, and the base member may be formed in an extension of one of the fingers of the lead frame. According to a preferred embodiment of the present invention, a pair of additional fingers of the lead frame extend in parallel with the first mentioned finger in such a manner that the magneto-electric transducer ICs may be connected to the lead means via these fingers in a mutually parallel relationship.

Thus, according to the present invention, N and S poles can be detected with an extremely simple structure. Therefore, the cost can be significantly reduced as compared with designing a special IC, and the size of the transducer can be significantly reduced as compared with forming a bidirectional magnetic field type transducer by using an external circuit or a specialized IC.

## BRIEF DESCRIPTION OF THE DRAWINGS

Now an embodiment of the present invention is described in the following with reference to the appended drawings, in which:

Figures 1(a) and 1(b) are two perspective views showing an embodiment of the magneto-electric transducer according to the present invention from two different directions;

Figure 2 is a circuit diagram thereof;

Figure 3 is a perspective view showing the magneto-electric transducer of the present invention and a permanent magnet placed near it;

Figures 4(a) and 4(b) are wave form diagrams showing outputs obtained by the magneto-electric transducer of the present embodiment and a conventional magneto-electric transducer, respectively; and

Figures 5(a) and 5(b) are two perspective views showing a conventional magneto-electric transducer from two different directions

## DETAILED DESCRIPTION OF THE PREFERRED EMBODIMENT(S)

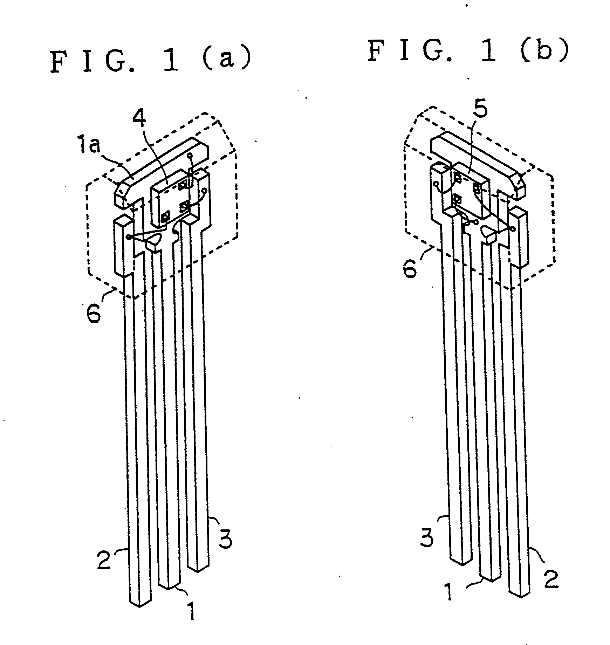

Figures 1(a) and (b) are perspective views showing a preferred embodiment of the magneto-electric transducer according to the present invention from two different directions. This magneto-electric transducer includes three fingers 1 through 3 of a lead frame, and a Hall IC 4 having a structure which is described hereinafter is mounted on a base 1a of one of the fingers 1 of the lead frame with its three terminals connected to the three fingers 1 through 3 of the lead frame, respectively, by wire bonding. Another Hall IC 5 having a similar structure is mounted on the reverse surface of the base 1a of the first finger 1 of the lead frame, and its terminals are likewise connected to the three fingers 1 through 3 of the lead frame, respectively, by wire boding. In this way, a magneto-electric transducer is formed by mounting the Hall ICs 4 and 5 on either major surface of the base 1a of the first finger 1 of the lead frame, and encapsulating them in a resin molding 6 as indicated by the broken lines in Figures 1(a) and 1-(b).

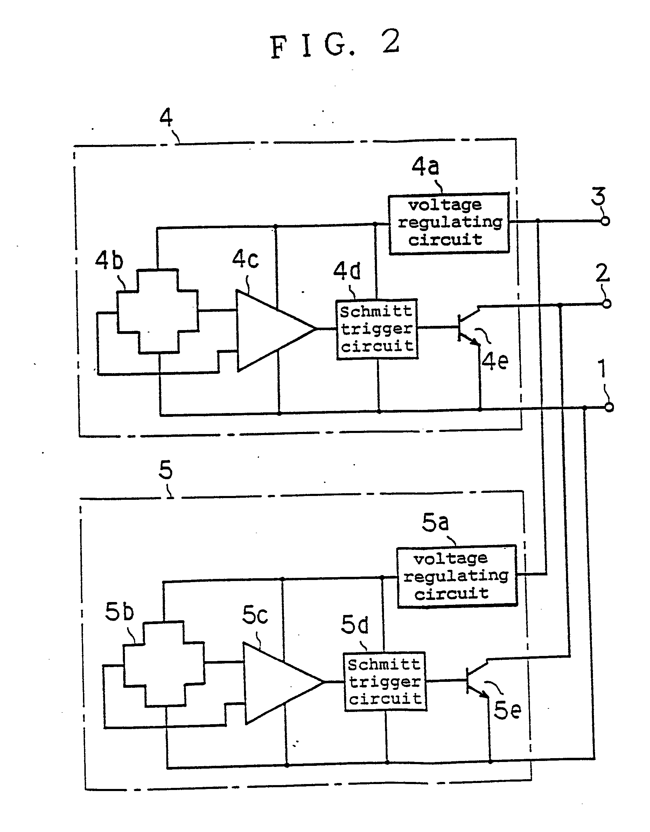

Figure 2 shows a circuit diagram showing the connection between the Hall ICs 4 and 5 and the different fingers 1 through 3 of the lead frame. As shown in this drawing, the ICs 4 and 5 are each provided with a Hall device 4b or 5b and a voltage regulating circuit 4a or 5a so that a constant voltage may be applied to each of the Hall devices 4b and 5b. The Hall devices 4b and 5b are adapted to detect the intensity of magnetic fields of different polarities, and their outputs are supplied to Schmitt trigger circuits 4d and 5d via amplifiers 4c and 5c, respectively. The Schmitt trigger circuits 4d and 5d discriminate the outputs from the amplifiers 4c and 5c according to a certain threshold level, and their outputs are supplied to an external circuit not shown in the drawings via output transistors 4e and 5e, respectively. The collectors of the output transistors 4e and 5e are commonly connected to the second finger 2 of the lead frame, and the positive and negative power inputs to the Hall ICs 4 and 5 are also commonly connected to the third and first fingers 3 and 1 of the lead frame, respectively.

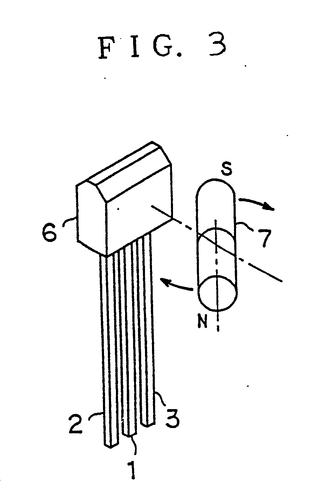

According to the magneto-electric transducer having such a structure, when a magnet 7 is rotated around an axis of rotation near the magneto-electric transducer as shown in Figure 3, since the Hall ICs 4 and 5 are activated in an alternating fashion as the N and S poles of this magnet 7 pass them, an output as shown in Figure 4(a) can be obtained. Thus, by mounting a pair of Hall devices on either side of a lead frame, it is possible to obtain a magneto-electric transducer which is sensitive to both N and S poles.

Although the present invention has been shown and described with respect to a detailed embodiment, it should be understood by those skilled in the art that various changes and omission in form and detail may be made therein without departing from the spirit or scope of this invention.

## Claims

1. A magneto-electric transducer, comprising
- a base member (1a);
- a pair of magneto-electric ICs (4, 5) mounted on said base member (1a) adjacent to each other; and
- lead means (1 to 3) for connecting leads of said magneto-electric ICs (4, 5) to an external circuit.

2. A magneto-electric transducer according to claim 1, wherein said base member (1a) consists of a planar member, and said magneto-electric ICs (4, 5) are mounted on either major surface of said base member (1a).

3. A magneto-electric transducer according to claim 1 or 2, wherein said lead means consists of a plurality of fingers (1 to 3) of a lead frame, and said base member (1a) is formed as an extension of one (1) of said fingers and further two fingers (2, 3) of said lead frame extend in parallel with said first one (1) of said fingers in such a manner that said magneto-electric transducer ICs (4, 5) may be connected to said fingers in a mutually parallel relationship.

FIG. 1 (a)

FIG. 1 (b)

# F I G. 2

# F I G. 3

OM 20 040 EP   PAe Kahler & Käck

EP 0 399 254 A2

F I G.  4  (a)

output
on
off
rotational angle

F I G.  4  (b)

output
on
off
N    S    N    S    N    S
rotational angle

# FIG. 5 (a)  FIG. 5 (b)